# FASCICULE DE BREVET EUROPEEN

(11) **EP 2 017 885 B1**
(45) Date de publication et mention de la délivrance du brevet: **22.06.2011**
(21) Numéro de dépôt: 08354046.8
(22) Date de dépôt: 25.06.2008
(51) Int. Cl.: H01L 21/768, H01L 23/522

(54) **Procédé de fabrication d'une connexion électrique à base de nanotubes et ayant des cavités d'air**
Verfahren zur Herstellung eines elektrischen Anschlusses auf der Basis von Nanoröhrchen sowie mit Luftisolation
Method of producing an electric connection using nanotubes and having air gaps

(30) Priorité: 17.07.2007 FR 0705153
(43) Date de publication de la demande: 21.01.2009
(73) Titulaire: Commissariat à l'Énergie Atomique et aux Énergies Alternatives, 75015 Paris (FR)
(72) Inventeur: Gaillard, Frédéric-Xavier, 38500 Voiron (FR); Coiffic, Jean-Christophe, 38000 Grenoble (FR)
(74) Mandataire: Hecké, Gérard

(56) Documents cités:
- EP-A- 1 361 608
- EP-A- 1 993 129
- JP-A- 2007 220 742
- US-A1- 2005 074 960

## Description

### Domaine technique de l'invention

L'invention est relative à un procédé de fabrication d'une connexion électrique à base de nanotubes, entre deux couches conductrices, respectivement inférieure et supérieure, séparées par une couche cible, procédé comportant successivement:
- la formation de la couche cible sur la couche conductrice inférieure,
- la formation dans la couche cible d'au moins un orifice comportant un fond,
- la croissance des nanotubes dans ledit orifice,
- la formation de la couche conductrice supérieure, reliée électriquement à la couche conductrice inférieure par les nanotubes,

### État de la technique

De nos jours, les circuits électroniques intégrés présentent une proportion non négligeable d'éléments métalliques. Ces derniers peuvent être utilisés en tant qu'éléments d'interconnexion, antennes, bobines ou inductances. Avec la réduction des distances séparant les couches métalliques, les couplages électrostatiques ou électromagnétiques augmentent entre ces éléments, ce qui a pour effet de modifier leur comportement électrique. D'une manière générale, ces couplages électrostatiques sont modélisés par l'apparition d'au moins une capacité parasite entre les éléments métalliques. La réduction du couplage passe par une diminution de la permittivité diélectrique du matériau se trouvant entre les éléments métalliques.

Pour les générations actuelles de circuits intégrés, l'utilisation de matériaux diélectriques à faible permittivité (de l'ordre de 2,3 à 2,7) est compatible avec les performances visées. Ces diélectriques à faible permittivité remplacent avantageusement les oxydes de silicium. Cependant, pour les générations technologiques à venir (noeuds inférieurs à 32nm), les besoins en performance sont nettement supérieurs à la faible amélioration de la permittivité actuellement mesurée sur les matériaux massifs déposés. L'utilisation de cavités d'air (« Air Gap » en anglais) dans les structures d'interconnexion semble aujourd'hui inévitable. Avec de telles architectures, les cavités d'air présentes entre les lignes de conducteurs apportent des permittivités égales à 1.

Actuellement, une voie possible pour la fabrication de ces cavités est l'utilisation d'un dépôt non-conforme de diélectrique sur des couches d'interlignes de matériau métallique. Cette approche, décrite par Gosset et al. (« General review of issues and perspectives for advanced copper interconnections using air gap as ultra-low K material », Proceeding of the IEEE, 2003, International Interconnect Technology Conference (2003) 65), permet d'obtenir, sous certaines conditions de fabrication et avec un surplus d'étapes technologiques complexes et coûteuses, les cavités recherchées.

Une autre solution envisagée consiste à intégrer un matériau sacrificiel entre les motifs en matériau métallique, formant ainsi le niveau intermétallique. Ce matériau réagit après son intégration au moyen de divers procédés physico-chimiques, (par exemple par recuit thermique, traitement par rayonnement UV (« Benefits and Trade-offs in Multi-Level Air Gap Integration », Spring MRS San Diego, avril 2006), ou attaque chimique (brevet US7172980). De cette manière, il est possible de réaliser en totalité ou en partie, l'intégration des niveaux d'interconnexions avec le matériau sacrificiel, puis de former les cavités d'air. Cependant, cette approche limite fortement l'étendue des matériaux utilisables lors de l'intégration. Le matériau sacrificiel, qui doit laisser place à la cavité, doit en effet être compatible avec la technologie des semi-conducteurs, être dégradable et, tout comme son retrait, les procédés physico-chimiques utilisés ne doivent pas détériorer les dispositifs électroniques déjà intégrés (transistors CMOS, capacités...). De même, les matériaux jouxtant le matériau sacrificiel doivent présenter une tenue à ces procédés physico-chimiques, afin de ne pas s'altérer, mais certains de ces matériaux doivent permettre la dégradation et le retrait du matériau sacrificiel en étant, par exemple, perméables aux multiples processus chimiques.

Par ailleurs, les nanotubes de carbone font actuellement l'objet d'un effort important de recherche car leur structure cylindrique monoatomique leur confère des propriétés exceptionnelles à l'échelle nanométrique. Une application prometteuse consiste à utiliser les nanotubes dans les interconnexions, notamment dans l'industrie de la microélectronique, comme décrit par Nihei et al. (« Electrical Properties of Carbon nanotube Bundles for Future Via Interconnects » Japanese Journal of Applied Physics Vol. 44 N°4A, 2005 pp1626-1628). Ces interconnexions sont constituées par deux lignes de métal conductrices, actuellement en cuivre, situées l'une au-dessus de l'autre, formant ainsi deux niveaux métalliques reliés par des ponts conducteurs appelés vias.

Pour supporter les contraintes imposées par la réduction des dimensions ajoutée à une complexification des paramètres d'intégration, il est envisagé d'utiliser des nanotubes de carbone comme fils nanométriques métalliques pour les interconnexions. Ceux-ci possèdent en effet des propriétés intrinsèques très intéressantes par rapport au cuivre. Une intégration de nanotubes de carbone dans une interconnexion microélectronique est décrite dans le document US-A-2003/0179559, dans lequel des nanotubes relient deux couches en matériaux conducteurs.

Le document US-A-2005/074960 décrit un procédé de formation des interconnexions comprenant des cavités d'air et optionnellement des vias formés par des nanotubes de carbone.

### Objet de l'invention

L'objet de l'invention a pour but un procédé visant à pallier les inconvénients précités, plus particulièrement un procédé de fabrication moins complexe et moins coûteux.

Selon l'invention, ce but est atteint par un procédé de réalisation selon les revendications annexées et plus particulièrement par le fait que le procédé comporte, entre la croissance des nanotubes et la formation de la couche conductrice supérieure,
- le dépôt d'une couche d'isolation plane, traversée par les nanotubes,
- la dégradation sélective de la couche cible, en matériau dégradable, les nanotubes, à parois poreuses, constituant des passages entre la couche cible et l'extérieur pour un agent de dégradation et/ou des sous-produits de dégradation formés pendant ladite dégradation sélective.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- Les figures 1 à 4 représentent les étapes successives d'un premier mode de réalisation du procédé selon l'invention.
- Les figures 5 et 6 représentent les étapes successives d'un deuxième mode de réalisation du procédé selon l'invention.
- Les figures 7 et 8 représentent diverses étapes d'un troisième mode de réalisation du procédé selon l'invention.

### Description de modes de réalisation particuliers de l'invention

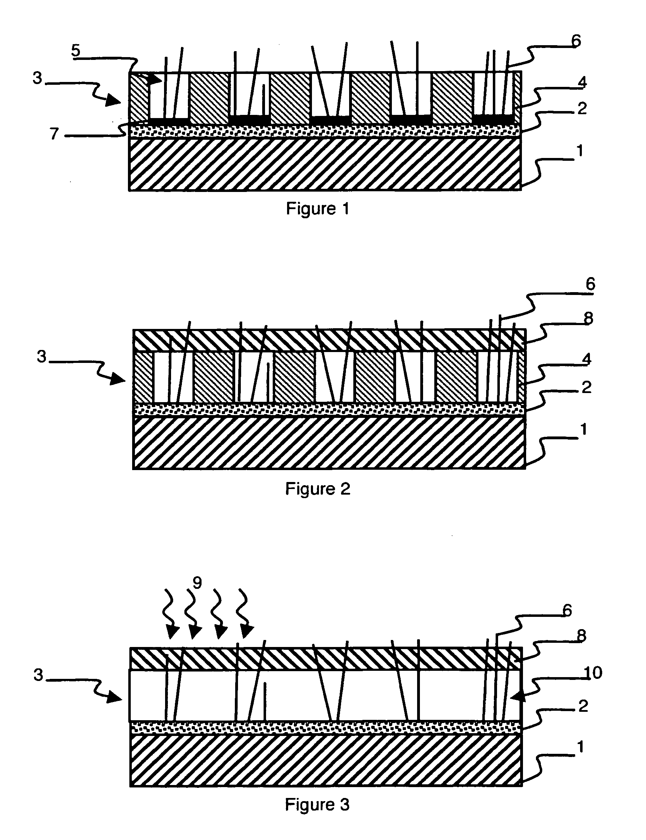

Dans un premier mode de réalisation, illustré sur la figure 1, une couche cible 3 est réalisée sur une couche conductrice inférieure 2, elle-même déposée sur un substrat 1. Dans ce mode particulier de réalisation, la couche cible 3 est uniquement composée d'un matériau dégradable 4. Cependant, la couche cible 3 peut être formée de plusieurs matériaux dégradables ayant des agents de dégradation différents et peut comporter au moins un matériau non dégradable. Le matériau dégradable 4 est, par exemple, de la silice (SiO₂), qui peut être dégradé par attaque chimique, ou un polymère thermiquement dégradable, tel que du polyméthylméthacrylate ou de l'alpha-terpinène. La couche cible 3 est ensuite structurée par toute technique adaptée, par exemple par photolithographie et gravure afin de former des orifices 5. Ainsi, le fond de l'orifice 5 est formé par des zones prédéterminées, libres, de la couche conductrice inférieure 2. Les parois latérales des orifices 5 sont formées par le matériau dégradable 4.

Des nanotubes 6 sont ensuite formés, à partir de la couche conductrice inférieure 2, à l'intérieur des orifices 5, par tout procédé connu, par exemple par voie catalytique, par décharge électrique à haute température ou par ablation laser. Les nanotubes 6 présentent alors une extrémité en contact avec la couche conductrice inférieure 2.

Comme illustré à la figure 1, une couche de catalyseur 7, permettant la croissance des nanotubes 6, est avantageusement formée dans le fond des orifices 5. Le catalyseur 7 est par exemple en Co, Ni, Fe, Al, Al₂O₃, Fe₂O₃, Mo. Il peut également être réalisé par un dépôt auto-positionné et est alors, par exemple, en CoWP, CoWP/B, NiMoP, NiMoB, leurs oxydes ou leurs alliages. Le catalyseur 7 peut être déposé sous forme d'agrégats ou peut être composé de multicouches de différents catalyseurs. Dans certains cas de figure, le catalyseur 7 peut être précédé du dépôt d'une couche barrière et/ou d'une couche d'accroche dans le fond des orifices 5.

Les nanotubes 6 sont, par exemple, des nanotubes de carbone et sont, préférentiellement de forme cylindrique creuse. Les nanotubes 6 ne sont pas forcément strictement verticaux et peuvent également être tordus. La majorité des nanotubes 6 est sensiblement perpendiculaire à la surface du substrat 1 sur lequel ils sont formés.

Dans le cas de nanotubes 6 de carbone, la croissance des nanotubes peut être réalisée par toute technique adaptée, par exemple par dépôt chimique en phase vapeur CVD, dépôt chimique en phase vapeur assisté par plasma PECVD, résonance électron cyclotron (« Electron Cyclotron Resonance ») PECVD, dépôt chimique en phase vapeur avec filament à chaud, dépôt chimique en phase vapeur assisté laser... Préférentiellement, une technique permettant la croissance de nanotubes 6 de carbone à partir d'un catalyseur et à une température inférieure à 900°C est utilisée. Les gaz employés lors de la formation de nanotubes de carbone peuvent être du CO, C₂H₂, CH₄, Fe(C₅H₅)₂, du xylène, des métallocènes, les alcools à l'état gazeux et tous les gaz carbonés, H₂, NH₃, H₂O, O₂ ou un mélange de ces gaz. Le carbone peut également être apporté grâce à une sole en graphite, bombardée par un plasma.

Comme illustré sur la figure 2, une couche d'isolation 8, sensiblement plane, est ensuite déposée sur la couche cible 3 et les nanotubes 6. Le dépôt de la couche d'isolation 8 est avantageusement de type non-conforme. De cette manière, la couche 8 n'enrobe pas complètement les motifs en couche cible 3 et les nanotubes 6 mais forme un film continu sensiblement horizontal et uniforme, formant ainsi des cavités d'air en refermant les orifices 5. Le procédé de dépôt de la couche 8 est classique car il est couramment utilisé pour former des couches isolantes dans des structures d'interconnexion. La couche d'isolation 8 peut présenter une certaine tenue mécanique afin de permettre le maintien des nanotubes 6 ou de la structure sur laquelle la couche 8 est déposée.

Selon les conditions de dépôt de la couche d'isolation 8, les nanotubes 6 peuvent alors présenter ou non une extrémité libre, c'est-à-dire une extrémité non enrobée par la couche d'isolation 8. Dans le cas où la majorité des nanotubes 6 ne traverse pas, de part en part, la couche d'isolation 8, une étape supplémentaire (non représentée) est nécessaire pour libérer l'extrémité supérieure des nanotubes 6. La majorité des nanotubes traverse alors la couche d'isolation 8 et constitue des passages entre la couche cible 3 ou la couche conductrice inférieure 2 et l'extérieur. Cette étape supplémentaire est réalisée par tout moyen connu et peut être, par exemple, constituée par un polissage mécano-chimique, une gravure par plasma ou une gravure par voie humide, qui élimine spécifiquement la couche d'isolation 8.

La couche d'isolation 8 est, préférentiellement, suffisamment rigide (suffisamment dense et avec un module d'Young approprié) pour ne pas se déformer, ou peu se déformer, une fois que les cavités d'air sont formées dans la couche cible 3. Avantageusement, des éléments de support (non représentés) sont intégrés dans la structure, afin d'accroître la tenue mécanique. De même, la couche d'isolation 8 est choisie de façon à ne pas être attaquée lors du processus de dégradation du matériau dégradable 4. La couche 8 est, préférentiellement, imperméable à l'agent d'attaque chimique utilisée pour dégrader le matériau 5 ainsi qu'aux sous-produits de dégradation. Avantageusement, la couche d'isolation 8 est en matériau diélectrique et, encore plus avantageusement, en matériau diélectrique à faible constante diélectrique (de l'ordre de 2 à 5). Cette couche d'isolation 8 a une épaisseur typiquement dans la gamme 20-500nm.

Avantageusement, la couche d'isolation 8 est de type Méthylsilsesquioxane et plus particulièrement en matériau BD1® commercialisée par la société Applied Materials.

L'ensemble ainsi formé est soumis à des agents de dégradation du matériau dégradable 4. Cette dégradation peut être réalisée par tout procédé connu, par exemple par un procédé thermique, par rayonnement (par exemple rayonnement ultraviolet) ou par tout phénomène ondulatoire approprié ou par attaque chimique par un agent sous forme liquide ou gazeux.

Comme illustré sur la figure 3, dans le cas d'une attaque chimique par un agent 9 sous forme liquide, l'agent peut, par exemple, être disposé sous forme d'une solution sur la couche d'isolation 8. L'agent peut alors, à travers les nanotubes 6 traverser la couche d'isolation 8, puis, en traversant les parois poreuses des nanotubes, parvenir dans les orifices 5 et dégrader le matériau sacrificiel 4. L'agent 9 peut également traverser la couche d'isolation 8 le long des parois externes des nanotubes 6 dans le cas où ces derniers ne sont pas parfaitement jointifs avec la couche d'encapsulation 8. Les nanotubes, ayant des parois poreuses aux agents chimiques et aux sous-produits de réaction, constituent ainsi des passages pour le liquide ou le gaz entre la couche cible 3 et l'extérieur. La formation de nanotubes destinés à servir de passage à un gaz ou à un liquide dans le domaine de la biologie a notamment été décrite dans l'article « Enhanced flow in carbone nanotubes » Nature, 438 (2005), p.44. Cependant cet article ne mentionne pas les pertes de fluide dues à la porosité des parois latérales et les pertes le long des parois.

Les caractéristiques des nanotubes 6, en particulier leur diamètre, sont définies, dans le cas d'une attaque chimique, de manière à autoriser leur traversée par un agent capable de dégrader le matériau dégradable 4. Si l'on utilise un procédé de dégradation thermique ou ondulatoire du matériau dégradable 4, les nanotubes 6 ne sont pas utilisés par l'agent de dégradation. Cependant, dans tous les cas, les caractéristiques des nanotubes 6 doivent être choisies de façon à permettre aux sous-produits de la dégradation du matériau dégradable 4 d'être éliminés vers l'extérieur par l'intermédiaire des nanotubes (parois poreuses et orifices central des nanotubes).

La formation de passages constitués par les nanotubes 6 entre la couche cible 3 et l'extérieur, au sein de la couche d'isolation 8, permet ainsi à un agent 9, par exemple chimique, d'atteindre et de dégrader le matériau dégradable 4 et, après dégradation du matériau 4, aux résidus de dégradation d'être éliminés à travers la couche d'isolation 8 pour créer ou agrandir des cavités d'air 10, adjacente aux nanotubes traversant la couche cible 3, comme illustré à la figure 3.

Ainsi, l'agent 9 de dégradation chimique provenant de l'extérieur entre dans le nanotube 6 creux, traverse la couche d'isolation 8 puis passe aux travers des parois du nanotube et/ou passe le long des parois externes des nanotubes afin d'atteindre le matériau dégradable 4 de la couche cible 3. De manière analogue, après la dégradation sélective du matériau dégradable 4, le sous-produit de dégradation formé suit le même chemin en sens inverse.

La dégradation et l'élimination du matériau 4 est de préférence totale. Comme illustré sur la figure 3, les cavités d'air 10 ainsi formées au sein de la couche cible 3, remplacent alors totalement le matériau dégradable 4, qui constitue ainsi un matériau sacrificiel.

Lorsque les nanotubes 6 sont des nanotubes de carbone, la diffusion de l'agent de dégradation et/ou des sous-produits de dégradation par l'intermédiaire des nanotubes s'effectue par l'intermédiaire des parois des nanotubes, de l'interface nanotube-couche d'isolation et du canal creux du nanotube 6. Les nanotubes 6 peuvent également être en oxyde de titane, en nitrure de gallium ou à base de composés de terres rares.

Avantageusement, si l'on souhaite obtenir des nanotubes 6, réalisés par voie catalytique, complètement creux, les grains de catalyseurs utilisés pour leur formation peuvent être éliminés, par exemple, au moyen d'une solution d'acide (par exemple d'acide nitrique HNO₃).

Le diamètre des nanotubes 6 est choisi en fonction de l'application recherchée ainsi qu'en fonction du procédé de dégradation et des sous-produits en découlant, typiquement entre 1 nm et 300nm. En effet, plus le nanotube 6 est large et plus la diffusion des espèces chimiques (agent 9) est aisée. De même, les sous-produits de dégradation sont susceptibles d'être évacués beaucoup plus rapidement si le nanotube 6 est large.

Si une attaque très localisée est recherchée, l'utilisation de nanotubes 6 fins sera favorisée, ainsi que des procédés de dégradation adaptés (temps relativement court d'attaque chimique ou de recuit). Si, au contraire, de larges cavités sont recherchées autour des nanotubes 6, alors des nanotubes 6 larges seront réalisés, éventuellement avec un agent 9 de dégradation chimique très concentré, ou un temps d'attaque plus long sera utilisé. L'homme du métier adaptera le temps de gravure à la concentration de la solution d'attaque chimique.

La densité de nanotubes 6 est également choisie selon l'application recherchée. Cette densité de nanotubes 6 est préférentiellement de l'ordre de 10¹⁰ nanotube/cm². Avec une densité de nanotubes de cet ordre, la diffusion de l'agent de dégradation est aisée tout comme l'évacuation des sous-produits de dégradation. De plus, une telle densité de nanotubes aide à la tenue mécanique de l'ensemble de la structure et facilite l'éventuelle formation de niveaux d'interconnexion additionnels.

Dans le cas où le matériau dégradable 4 est constitué par de l'oxyde de silicium, sa dégradation peut être réalisée par de l'acide fluorhydrique. Le matériau de la couche 8 est alors choisi de façon à ne pas réagir avec l'acide fluorhydrique, et la couche 8 est alors, par exemple, en nitrure de silicium ou en carbure de silicium ou en SiOC.

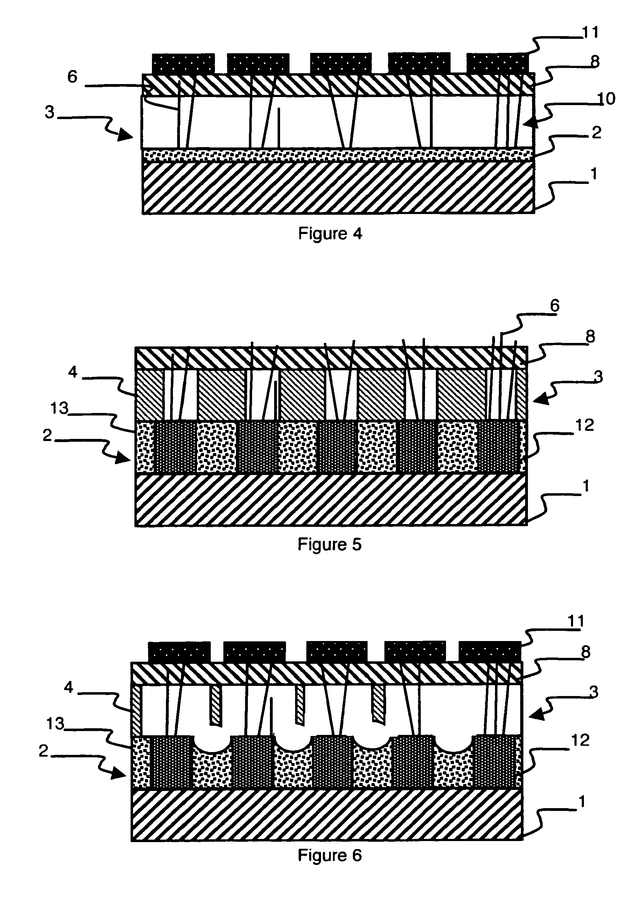

Comme illustré à la figure 4, le matériau dégradable 4 étant au moins partiellement éliminé, une couche conductrice supérieure 11 est ensuite déposée et structurée afin de connecter l'extrémité supérieure des nanotubes 6 débouchant de la couche d'isolation 8. Ainsi, une connexion électrique entre la couche conductrice 2 et les motifs de la couche conductrice supérieure 11, avantageusement en matériau métallique, est réalisée au moyen des nanotubes 6. De manière classique, un ou plusieurs niveau d'interconnexion peut être réalisé à partir de la couche conductrice supérieure 11. A ce moment, il n'est plus possible d'utiliser les nanotubes 6 en tant que chemin de diffusion d'un agent 9 de dégradation ou d'un sous-produit de dégradation.

Dans un second mode de réalisation, illustré à la figure 5, la couche conductrice inférieure 2 est constituée par un premier niveau d'interconnexion constitué de motifs (par exemple des plots de contact ou des lignes) en matériau électriquement conducteur 12 et en matériau isolant 13.

Comme précédemment, pour intégrer des cavités d'air dans cette structure d'interconnexion métallique, la couche cible 3 peut être uniquement constituée d'un matériau dégradable 4, par exemple de l'oxyde de silicium. Le matériau électriquement conducteur 12 de la couche conductrice inférieure 2 est, par exemple métallique (par exemple du cuivre), tandis que le matériau isolant 13 est identique au matériau dégradable 4. Ainsi lors de l'action de l'agent de dégradation, les matériaux 4 et 13 vont être au moins partiellement éliminés (figure 6).

Dans une variante de ce mode de réalisation, le matériau 4 est dégradable thermiquement, les autres matériaux pouvant rester inchangés. Le matériau dégradable 4 est alors, par exemple, de type polymère (par exemple en polyméthylmétacrylate PMMA, de type porogène en Norbornadiène ou alpha-terpinène...). Dans cette approche, la structure est alors chauffée de manière à réaliser la dégradation thermique du matériau dégradable 4. Comme précédemment, les sous-produits de dégradations peuvent alors diffuser hors de la couche cible 3 par l'intermédiaire des nanotubes 6 dont les parois et les orifices centraux font office de passages.

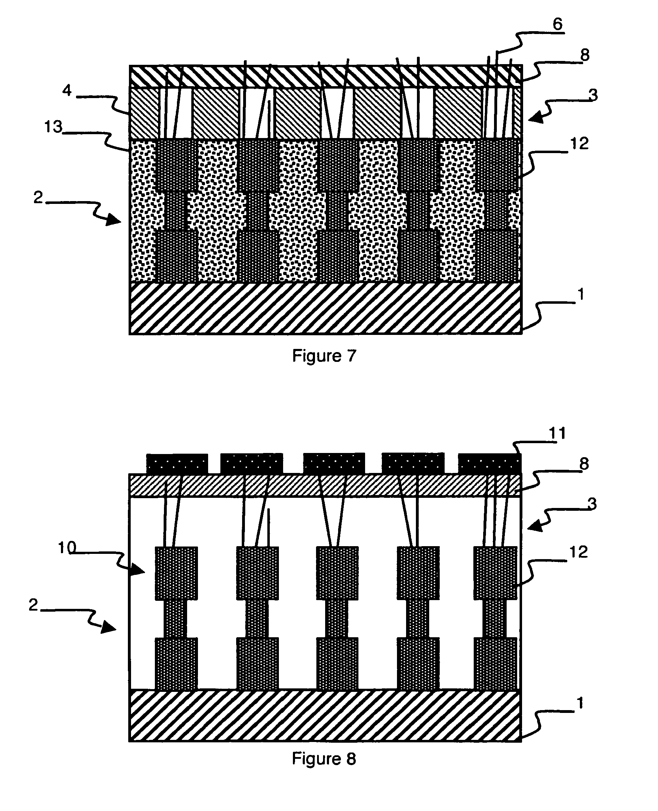

Dans un troisième mode de réalisation, illustré à la figure 7, la couche conductrice inférieure 2 comporte plusieurs niveaux d'interconnexion superposés constitués de motifs (par exemple des plots de contact ou des lignes) en matériau électriquement conducteur 12, préférentiellement métallique, par exemple en cuivre, au sein d'une matrice en matériau isolant 13, de préférence dégradable. Cette intégration peut être réalisée par toute technique connue, par exemple par la technique damascène.

Dans ce mode de réalisation, le substrat comporte alors une pluralité de niveaux d'interconnexion comportant des motifs en matériau métallique au sein d'une matrice en matériau dégradable. Les orifices 5 dans la couche cible 3 ont avantageusement été localisés en regard des motifs en matériau 12, de manière à permettre la croissance des nanotubes 6 depuis les motifs en matériau métallique de la couche 2. Comme précédemment, le retrait du matériau dégradable des divers niveaux d'interconnexion est alors réalisé à travers les parois et orifices centraux des nanotubes et une structure à cavité d'air est facilement obtenue (figure 8).

Comme sur la figure 4, lorsque les cavités d'air ont été formées dans la couche cible 3, la couche conductrice supérieure 11 est déposée. La couche conductrice supérieure 11 est alors en contact électrique avec la couche conductrice inférieure 2 ou les divers niveaux d'interconnexion au moyen des nanotubes 6.

## Revendications

1. Procédé de fabrication d'une connexion électrique à base de nanotubes (6), entre deux couches (2, 11) conductrices, respectivement inférieure et supérieure, séparées par une couche cible (3), procédé comportant successivement:
- La formation de la couche cible (3) sur la couche conductrice inférieure (2),
- la formation dans la couche cible (3) d'au moins un orifice (5) comportant un fond,
- la croissance des nanotubes (6) dans ledit orifice (5),
- la formation de la couche conductrice supérieure (11), reliée électriquement à la couche conductrice inférieure (2) par les nanotubes (6),
procédé **caractérisé en ce qu'**il comporte, entre la croissance des nanotubes (6) et la formation de la couche conductrice supérieure (11),
- le dépôt d'une couche d'isolation (8) plane, traversée par les nanotubes (6),
- la dégradation sélective de la couche cible (3), en matériau dégradable (4), les nanotubes (6), à parois poreuses, constituant des passages entre la couche cible (3) et l'extérieur pour un agent (10) de dégradation et/ou des sous-produits de dégradation formés pendant ladite dégradation sélective.

2. Procédé selon la revendication 1, **caractérisé en ce qu'**il comporte avant la croissance des nanotubes (6), la formation d'une couche de catalyseur (7) dans le fond de l'orifice (5).

3. Procédé selon l'une des revendications 1 et 2, **caractérisé en ce que** la dégradation sélective de la couche cible (3) est réalisée par attaque chimique, par l'intermédiaire des nanotubes (6), la couche d'isolation (8) étant imperméable audit agent (10) chimique, l'agent chimique et les sous-produits de dégradation étant acheminés à travers les parois des nanotubes (6) et/ou le long des parois des nanotubes (6).

4. Procédé selon l'une des revendications 1 et 2, **caractérisé en ce que** la dégradation sélective de la couche cible (3) est réalisée par un procédé thermique, les sous-produits de dégradation étant acheminés à travers les parois des nanotubes (6) et/ou le long des parois des nanotubes (6).

5. Procédé selon l'une des revendications 1 et 2, **caractérisé en ce que** la dégradation sélective de la couche cible (3) est réalisée par rayonnement, les sous-produits de dégradation étant acheminés à travers les parois des nanotubes (6) et/ou le long des parois des nanotubes (6).

6. Procédé selon l'une quelconque des revendications 1 à 5, **caractérisé en ce que** la couche cible (3) étant en oxyde de silicium, la dégradation chimique est réalisée au moyen d'acide fluorhydrique.

7. Procédé selon l'une quelconque des revendications 1 à 6, **caractérisé en ce que** les nanotubes (6) sont des nanotubes de carbone.

8. Procédé selon l'une quelconque des revendications 1 à 7, **caractérisé en ce que** la couche conductrice inférieure (2) étant constituée par un niveau d'interconnexion métallique comportant des motifs en matériau isolant (13), dégradable, et électriquement conducteur (12), la dégradation sélective de la couche cible (3) élimine les motifs en matériau isolant.

9. Procédé selon l'une quelconque des revendications 1 à 7, **caractérisé en ce que** la couche conductrice inférieure (2) étant constituée par un niveau d'interconnexion métallique comportant des motifs en matériau isolant (13) et en matériau électriquement conducteur (12), les orifices (5) sont formés dans la couche cible (3) en regard des motifs en matériau électriquement conducteur (12).

10. Procédé selon la revendication 9, **caractérisé en ce que** la couche conductrice inférieure (2) comporte plusieurs niveaux d'interconnexion métallique superposés.

## Claims

1. A fabrication method of a nanotube-based electric connection between two conducting layers (2, 11), respectively bottom and top, separated by a target layer (3), method successively comprising:
- formation of the target layer (3) on the bottom conducting layer (2),
- formation in the target layer (3) of at least one hole (5) comprising a bottom,
- growth of the nanotubes (6) in said hole (5),
- formation of the top conducting layer (11) electrically connected to the bottom conducting layer (2) by the nanotubes (6),
a method comprising, between growth of the nanotubes (6) and formation of the top conducting layer (11),
- deposition of a flat insulating layer (8) through which the nanotubes (6) pass,
- selective decomposition of the target layer (3), made of decomposable material (4), the nanotubes (6) with porous walls forming passages between the target layer (3) and the outside for a decomposition agent (10) and/or decomposition by-products formed during said selective decomposition.

2. The method according to claim 1, **characterized in that** it comprises formation of a catalyst layer (7) in the bottom of the hole (5) before growth of the nanotubes (6).

3. The method according to one of the claims 1 and 2, **characterized in that** the selective decomposition of the target layer (3) is performed by chemical etching by means of the nanotubes (6), the insulating layer (8) being impervious to said chemical agent (10), the chemical agent and the decomposition by-products being conveyed through the walls of the nanotubes (6) and/or along the walls of the nanotubes (6).

4. The method according to one of the claims 1 and 2, **characterized in that** the selective decomposition of the target layer (3) is performed by a thermal process, the decomposition by-products being conveyed through the walls of the nanotubes (6) and/or along the walls of the nanotubes (6).

5. The method according to one of the claims 1 and 2, **characterized in that** the selective decomposition of the target layer (3) is performed by radiation, the decomposition by-products being conveyed through the walls of the nanotubes (6) and/or along the walls of the nanotubes (6).

6. The method according to any one of the claims 1 to 5, **characterized in that** the target layer (3) being made from silicon oxide, chemical decomposition is performed by means of hydrofluoric acid.

7. The method according to any one of the claims 1 to 6, **characterized in that** the nanotubes are carbon nanotubes (6).

8. The method according to any one of the claims 1 to 7, **characterized in that** the bottom conducting layer (2) being formed by a metallic interconnect level comprising patterns made from decomposable insulating material (13), and patterns made from electrically conducting material, selective decomposition of the target layer (3) eliminates the insulating material patterns.

9. The method according to any one of the claims 1 to 7, **characterized in that** the bottom conducting layer being formed by a metallic interconnect level comprising patterns made from insulating material (13) and patterns made from electrically conducting material (12), the holes (5) are formed in the target layer (3) facing the patterns made of electrically conducting material (12).

10. The method according to claim 9, **characterized in that** the bottom conducting layer (2) comprises several superposed metallic interconnect levels.

## Patentansprüche

1. Verfahren zur Herstellung einer elektrischen Verbindung auf Basis von Nanoröhren (6) zwischen zwei leitenden Schichten (2, 11), und zwar einer unteren bzw. einer oberen, die durch eine Zielschicht (3) getrennt sind, Verfahren, das nacheinander folgende Schritte umfasst:
- Bildung der Zielschicht (3) auf der unteren leitenden Schicht (2),
- Bildung, in der Zielschicht (3), von mindestens einer Öffnung (5) mit einem Boden,
- Wachstum der Nanoröhren (6) in der genannten Öffnung (5),
- Bildung der oberen leitenden Schicht (11), die durch die Nanoröhren (6) elektrisch mit der leitenden unteren Schicht (2) verbunden ist,
Verfahren, das **dadurch gekennzeichnet ist, dass** es zwischen dem Wachstum der Nanoröhren (6) und der Bildung der oberen leitenden Schicht (11) folgende Schritte umfasst:
- Abscheiden einer ebenen, von den Nanoröhren (6) durchzogenen Isolierschicht (8),
- selektive Zerstörung der Zielschicht (3) aus zerstörbarem Material (4), wobei die Nanoröhren (6), die poröse Wände haben, zwischen der Zielschicht (3) und der äußeren Umgebung Durchlässe für ein Zerstörungsmittel und/oder Zerstörungsnebenprodukte bilden, die während der selektiven Zerstörung entstehen.

2. Verfahren nach Anspruch 1, **dadurch gekennzeichnet, dass**
es vor dem Wachstum der Nanoröhren (6) die Bildung einer Katalysatorschicht (7) am Boden der Öffnung (5) umfasst.

3. Verfahren nach einem der Ansprüche 1 und 2, **dadurch gekennzeichnet, dass**
die selektive Zerstörung der Zielschicht (3) durch chemisches Ätzen mit Hilfe der Nanoröhren (6) erfolgt, wobei die Isolierschicht (8) für das genannte chemische Mittel (10) undurchlässig ist, wobei das chemische Mittel und die Zerstörungsnebenprodukte durch die Wände der Nanoröhren (6) hindurch und/oder an den Wänden der Nanoröhren (6) entlang geleitet werden.

4. Verfahren nach einem der Ansprüche 1 und 2, **dadurch gekennzeichnet, dass**
die selektive Zerstörung der Zielschicht (3) mittels eines thermischen Verfahrens erfolgt, wobei die Zerstörungsnebenprodukte durch die Wände der Nanoröhren (6) hindurch und/oder an den Wänden der Nanoröhren (6) entlang geleitet werden.

5. Verfahren nach einem der Ansprüche 1 und 2, **dadurch gekennzeichnet, dass**
die selektive Zerstörung der Zielschicht (3) mittels Bestrahlung erfolgt, wobei die Zerstörungsnebenprodukte durch die Wände der Nanoröhren (6) hindurch und/oder an den Wänden der Nanoröhren (6) entlang geleitet werden.

6. Verfahren nach einem der Ansprüche 1 bis 5, **dadurch gekennzeichnet, dass**,
nachdem die Zielschicht (3) aus Siliziumoxid besteht, das chemische Ätzen mittels Flusssäure erfolgt.

7. Verfahren nach einem der Ansprüche 1 bis 6, **dadurch gekennzeichnet, dass**
die Nanoröhren (6) Kohlenstoffnanoröhren sind.

8. Verfahren nach einem der Ansprüche 1 bis 7, **dadurch gekennzeichnet, dass**,
nachdem die untere leitende Schicht (2) aus einer Metallverbindungsschicht besteht, die Strukturen aus zerstörbarem Material (13) und elektrisch leitendem Isoliermaterial (12) umfasst, durch die selektive Zerstörung der Zielschicht (3) die Strukturen aus Isoliermaterial entfernt werden.

9. Verfahren nach einem der Ansprüche 1 bis 7, **dadurch gekennzeichnet, dass**,
nachdem die untere leitende Schicht (2) aus einer Metallverbindungsschicht besteht, die Strukturen aus zerstörbarem Material (13) und aus elektrisch leitendem Isoliermaterial (12) umfasst, die Öffnungen (5) in der Zielschicht (3) gegenüber den Strukturen aus elektrisch leitendem Material (12) gebildet sind.

10. Verfahren nach Anspruch 9, **dadurch gekennzeichnet, dass**
die untere leitende Schicht (2) mehrere übereinander angeordnete Metallverbindungsschichten umfasst.
